# EUROPEAN PATENT APPLICATION

(11) **EP 3 208 325 A1**
(43) Date of publication of application: **23.08.2017**
(21) Application number: 15850772.3
(22) Date of filing: 14.10.2015
(51) Int. Cl.: C09K 3/10, H01L 51/50, H05B 33/02, H05B 33/04

(54) **SEALING MATERIAL COMPOSITION, SEALING SHEET, MEMBER FOR ELECTRONIC DEVICE, AND ELECTRONIC DEVICE**

(30) Priority: 16.10.2014 JP 2014211562
(71) Applicant: Lintec Corporation, Tokyo 173-0001 (JP)
(72) Inventor: NISHIJIMA, Kenta, Tokyo 173-0001 (JP)
(74) Representative: Beckmann, Claus
(86) International application number: PCT/JP2015/079061
(87) International publication number: WO 2016/060167

(57) **Abstract**

The present invention is a sealing material composition comprising a moisture absorbent, and a sealing resin having a weight average molecular weight of 50,000 to 1,000,000, the moisture absorbent comprising a compound that comprises a repeating unit represented by a formula (1), and 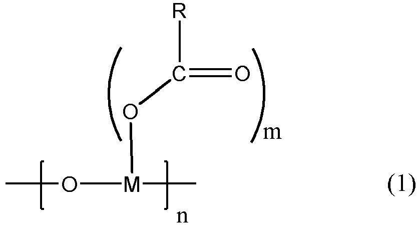 a sealing sheet, and
an electronic device member, and
an electronic device.

The sealing material composition according to the present invention makes it possible to easily produce a sealing sheet that exhibits excellent transparency, an excellent water vapor barrier capability, and high adhesion, and
the sealing sheet according to the present invention exhibits excellent transparency, an excellent water vapor barrier capability, and high adhesion, and may suitably be used to seal an organic EL device and the like, and
the electronic device member and the electronic device according to the present invention rarely deteriorate, and exhibit excellent long-term reliability.

## Description

### TECHNICAL FIELD

The present invention relates to a sealing material composition that makes it possible to easily produce a sealing sheet that exhibits excellent transparency, an excellent water vapor barrier capability, and high adhesion, a sealing sheet that includes a sealing layer that is formed using the sealing material composition, an electronic device member, and an electronic device.

### BACKGROUND ART

In recent years, organic electronics technology has attracted attention as technology that can form a display, a circuit, a cell, and the like on a flexible plastic substrate at a low temperature close to room temperature using a coating process or a printing process, and the research and development of various organic devices have progressed. For example, an organic electroluminescence (EL) device has attracted attention as a light-emitting device that can emit light with high brightness by means of low-voltage DC drive, and can be applied to a liquid crystal display and an EL display.

However, the organic EL device has a problem in that the emission properties (e.g., brightness, emission efficiency, and emission uniformity) deteriorate due to water vapor and the like. It is considered that deterioration in emission properties occurs since the plastic film used as the substrate and the sealing material easily allow water vapor and the like to pass through, and oxidation of the electrode, deterioration in organic material, oxidative decomposition of the organic material, and the like occur due to water vapor and the like that have entered the organic EL device.

In order to solve the above problem, a method that seals the organic EL device using a sealing sheet that has a barrier capability so that water vapor and the like do not come in contact with the organic EL device, has been studied.

A method that forms a silica deposited film is known as a method for providing a barrier capability. However, this method has a problem from the viewpoint of cost since expensive equipment is required to implement deposition.

Patent Literature 1 discloses an organoelectronic device wherein a water-trapping agent is disposed in a container that is hermetically sealed with an insulating element substrate and a sealing substrate so as to include a laminate in which an organic layer is sandwiched between a pair of electrodes, the water-trapping agent including an organometallic compound represented by the following formula (i) as a drying agent component, and being obtained by mixing the organometallic compound with an organic solvent, and replacing the organic solvent with a viscous replacement material that has compatibility with the drying agent component. 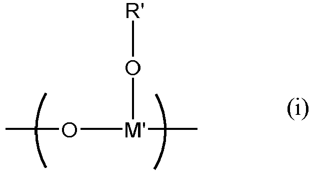 wherein R' is an organic group such as an alkyl group having 1 or more carbon atoms, an aryl group, an alkoxy group, a cycloalkyl group, a heterocyclic group, or an acyl group, and M' is a trivalent metal atom.

However, since a liquid material having an average molecular weight of 300 to 3,700 is used as the viscous replacement material, deterioration in handling capability occurs. It is considered that the invention disclosed in Patent Literature 1 uses a liquid material since the invention disclosed in Patent Literature 1 aims to provide fluidity during filling, and prevent physical disruption of the organic layer.

Patent Literature 1 is silent about a water vapor transmission rate and a water vapor barrier effect.

### CITATION LIST

### PATENT LITERATURE

Patent Literature 1: JP-A-2012-38660 (US2012037893A1)

### SUMMARY OF INVENTION

### TECHNICAL PROBLEM

The invention was conceived in view of the above situation. An object of the invention is to provide a sealing material composition that makes it possible to easily produce a sealing sheet that exhibits excellent transparency, an excellent water vapor barrier capability, and high adhesion, a sealing sheet that includes a sealing layer that is formed using the sealing material composition, an electronic device member, and an electronic device.

### SOLUTION TO PROBLEM

The inventor conducted extensive studies with regard to a sealing material composition that includes a sealing resin in order to solve the above problem. As a result, the inventor found that a sealing material composition that includes a sealing resin having a weight average molecular weight of 50,000 to 1,000,000, and a moisture absorbent that includes a compound including a repeating unit represented by the following formula (1), makes it possible to easily produce a sealing sheet that exhibits excellent transparency, an excellent water vapor barrier capability, and high adhesion. This finding has led to the completion of the invention.

Several aspects of the invention provide the following sealing material composition (see (1) to (5)), sealing sheet (see (6) to (8)), electronic device member (see (9)), and electronic device (see (10)).
(1) A sealing material composition including a moisture absorbent, and a sealing resin having a weight average molecular weight of 50,000 to 1,000,000, the moisture absorbent including a compound that includes a repeating unit represented by a formula (1), 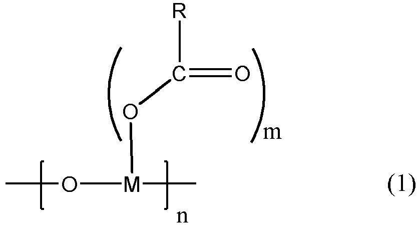 wherein M is an element selected from Al, Si, Ti, Ge, Zr, and a lanthanoid, R is an alkyl group having 1 to 30 carbon atoms, an alkenyl group having 2 to 30 carbon atoms, an aryl group having 6 to 30 carbon atoms, a cycloalkyl group having 3 to 20 carbon atoms, or a heterocyclic group, and n is a positive integer, provided that a plurality of repeating units represented by (-O-M(O-C(=O)-R)ₘ-) are either identical to or different from each other when n is equal to or larger than 2, m is 1 or 2, and a plurality of groups represented by -O-C(=O)-R are either identical to or different from each other when m is 2.
(2) The sealing material composition according to (1), wherein the sealing resin is a polyisobutylene-based resin.
(3) The sealing material composition according to (1) or (2), wherein the moisture absorbent is a compound represented by a formula (1-1), 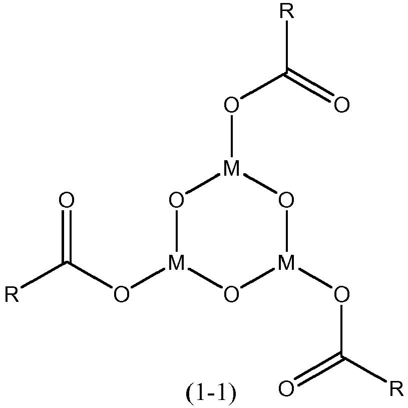 wherein R and M are the same as defined above.
(4) The sealing material composition according to any one of (1) to (3), including the moisture absorbent and the sealing resin in a mass ratio (moisture absorbent:sealing resin) of 10:100 to 100:100.
(5) The sealing material composition according to any one of (1) to (4), further including a tackifier.
(6) A sealing sheet including a sealing layer that is formed using the sealing material composition according to any one of (1) to (5).
(7) The sealing sheet according to (6), having a moisture absorption at a temperature of 40°C and a relative humidity of 90% of 0.5 g/m² or more.
(8) The sealing sheet according to (6) or (7), further including a gas barrier layer.
(9) An electronic device member including the sealing sheet according to any one of (6) to (8).
(10) An electronic device including the electronic device member according to (9).

### ADVANTAGEOUS EFFECTS OF INVENTION

The sealing material composition according to the invention makes it possible to easily produce a sealing sheet that exhibits excellent transparency, an excellent water vapor barrier capability, and high adhesion.

The sealing sheet according to the invention exhibits excellent transparency, an excellent water vapor barrier capability, and high adhesion, and may suitably be used to seal an organic EL device and the like.

The electronic device member and the electronic device according to the invention rarely deteriorate, and exhibit excellent long-term reliability.

### DESCRIPTION OF EMBODIMENTS

A sealing material composition, a sealing sheet, an electronic device member, and an electronic device according to the exemplary embodiments of the invention are described in detail below.

### 1) Sealing material composition

A sealing material composition according to one embodiment of the invention includes a moisture absorbent, and a sealing resin having a weight average molecular weight of 50,000 to 1,000,000, the moisture absorbent including a compound that includes a repeating unit represented by the following formula (1).

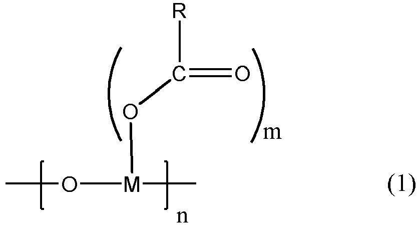

Note that the repeating unit represented by the formula (1) may be hereinafter referred to as "repeating unit (1)".

### (1) Moisture absorbent

The moisture absorbent used in connection with one embodiment of the invention includes the compound that includes the repeating unit (1). The moisture absorbent used in connection with one embodiment of the invention has a function of absorbing water (moisture) that has entered a layer.

M in the formula (1) is an element selected from Al, Si, Ti, Ge, Zr, and a lanthanoid. The term "lanthanoid" refers to the atoms respectively having an atomic number of 57 to 71. The valence of M is 3 or 4.

It is preferable that M have a valence of 3, and particularly preferably be Al(III), since the advantageous effects of the invention can be more easily achieved.

n is a positive integer, and preferably a positive integer from 1 to 1,000. A plurality of repeating units represented by (-O-M(O-C(=O)-R)ₘ-) are either identical to or different from each other when n is equal to or larger than 2.

m is 1 or 2. A plurality of groups represented by -O-C(=O)-R are either identical to or different from each other when m is 2.

R is an alkyl group having 1 to 30 (preferably 5 to 20, and more preferably 6 to 17) carbon atoms, an alkenyl group having 2 to 30 (preferably 5 to 20, and more preferably 6 to 17) carbon atoms, an aryl group having 6 to 30 (and preferably 6 to 10) carbon atoms, a cycloalkyl group having 3 to 20 (and preferably 5 to 10) carbon atoms, or a heterocyclic group.

The alkyl group having 1 to 30 carbon atoms that may be represented by R may be linear or branched. Examples of the alkyl group having 1 to 30 carbon atoms that may be represented by R include a methyl group, an ethyl group, a propyl group, a butyl group, a pentyl group, a hexyl group, a heptyl group, an octyl group, a nonyl group, a decyl group, a dodecyl group, an undecyl group, a tridecyl group, a tetradecyl group, a pentadecyl group, a hexadecyl group, a heptadecyl group, an octadecyl group, a nonadecyl group, an icosyl group, a heneicosyl group, a docosyl group, and the like (including all positional isomers).

Examples of the alkenyl group having 2 to 30 carbon atoms include a vinyl group, an allyl group, a butenyl group, a pentenyl group, a hexenyl group, and the like (including all positional isomers).

The alkyl group and the alkenyl group may be substituted with a substituent at an arbitrary position. Examples of the substituent include a cyano group; a halogen atom such as a fluorine atom, a chlorine atom, a bromine atom, and an iodine atom; an alkoxy group such as a methoxy group and an ethoxy group; an aryl group such as a phenyl group; and the like.

Examples of the aryl group having 6 to 30 carbon atoms include a phenyl group, a 1-naphthyl group, a 2-naphthyl group, an anthranyl group, a phenanthrenyl group, a fluorenyl group, a pyrenyl group, and the like.

Examples of the cycloalkyl group having 3 to 20 carbon atoms include a cyclopropyl group, a cyclopentyl group, a cyclohexyl group, a cycloheptyl group, a cyclooctyl group, a norbornyl group, an adamantyl group, and the like.

The heterocyclic group is not particularly limited as long as the heterocyclic group is a group that is derived from a 3 to 10-membered heterocyclic compound that includes a carbon atom and at least one heteroatom (e.g., oxygen atom, nitrogen atom, or sulfur atom).

Specific examples of the heterocyclic group include an unsaturated 5-membered heterocyclic group such as a pyrrol-2-yl group, a pyrrol-3-yl group, a furan-2-yl group, a furan-3-yl group, a thiophen-2-yl group, a thiophen-3-yl group, an oxazol-2-yl group, an oxazol-4-yl group, an oxazol-5-yl group, a thiazol-2-yl group, a thiazol-4-yl group, a thiazol-5-yl group, an isoxazol-3-yl group, an isoxazol-4-yl group, an isoxazol-5-yl group, an isothiazol-3-yl group, an isothiazol-4-yl group, an isothiazol-5-yl group, an imidazol-2-yl group, an imidazol-4-yl group, an imidazol-5-yl group, a pyrazol-3-yl group, a pyrazol-4-yl group, a pyrazol-5-yl group, a 1,3,4-oxadiazol-2-yl group, a 1,3,4-thiadiazol-2-yl group, a 1,2,3-triazol-4-yl group, a 1,2,4-triazol-3-yl group, and a 1,2,4-triazol-5-yl group; an unsaturated 6-membered heterocyclic group such as a pyridin-2-yl group, a pyridin-3-yl group, a pyridin-4-yl group, a pyridazin-3-yl group, a pyridazin-4-yl group, a pyrazin-2-yl group, a pyrimidin-5-yl group, a 1,3,5-triazin-2-yl group, and a 1,2,4-triazin-3-yl group; and the like.

The aryl group, the cycloalkyl group, and the heterocyclic group may be substituted with a substituent at an arbitrary position. Examples of the substituent include an alkyl group such as a methyl group and an ethyl group; a cyano group; a halogen atom such as a fluorine atom, a chlorine atom, and a bromine atom; an alkoxy group such as a methoxy group and an ethoxy group; an aryl group such as a phenyl group and a biphenyl group; and the like.

The compound that includes the repeating unit (1) may have a cyclic structure, or may have a chain-like structure, or may have a cyclic structure and a chain-like structure.

Specific examples of the compound that includes the repeating unit (1) include, but are not limited to, compounds respectively represented by the following formulas (1-1) to (1-5). Note that the formula (1-5) represents that the compound includes at least one repeating unit represented by the formula (1-5). 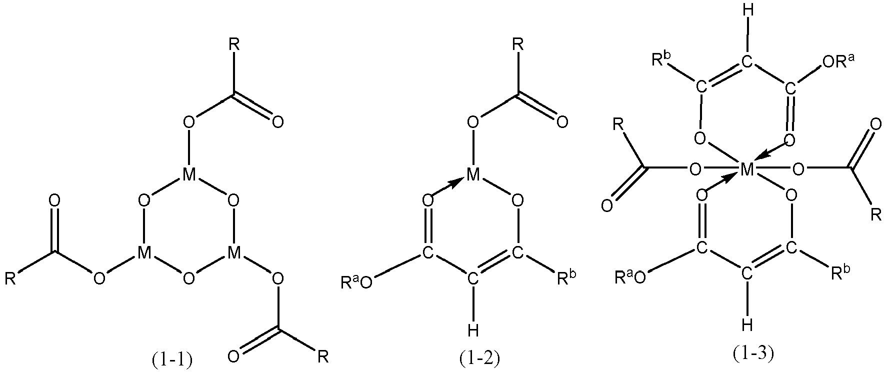 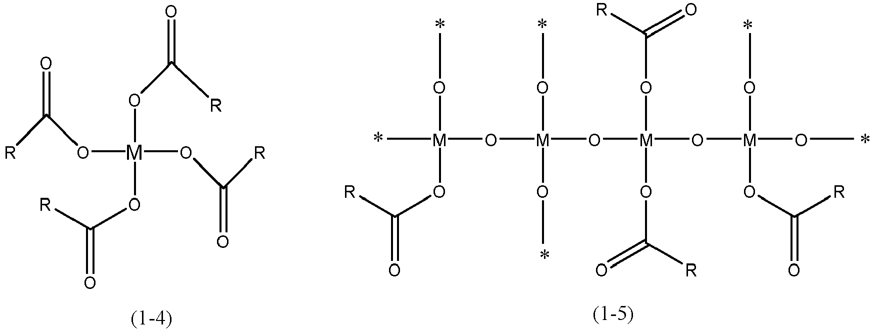 wherein R and M are the same as defined above, R^{a} and R^{b} are independently an alkyl group (e.g., methyl group or ethyl group), and "*" is a bonding position (hereinafter the same).

It is preferable that the compound that includes the repeating unit (1) have a cyclic structure, and more preferably be the compound represented by the formula (1-1), since the advantageous effects of the invention are further improved. It is preferable that the compound represented by the formula (1-1) have a structure in which M is Al, and particularly preferably a structure in which M is Al, and the carbon atom included in R that is bonded to the carbonyl group is a primary carbon atom.

It is considered that a compound represented by the following formula (2-1) reacts with water when water is present, to produce an alcohol compound represented by the following formula (b). 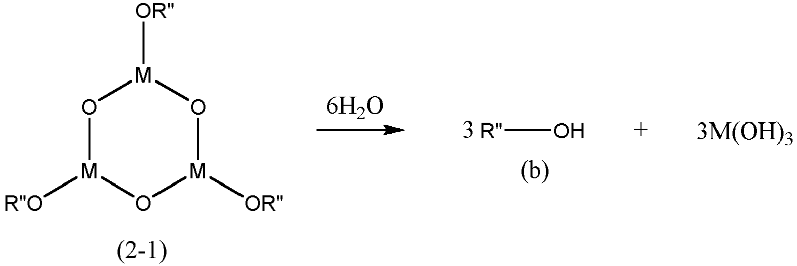 wherein M is the same as defined above, and R" is the same as defined above in connection with R.

It is considered that an alcohol compound adversely affects an organic EL device and the like in the same manner as water (moisture).

Since the compound that includes the repeating unit (1) that is used in connection with one embodiment of the invention does not react with water and produce an alcohol compound, the compound that includes the repeating unit (1) is suitable as a moisture absorbent that is used for an electronic device and the like.

In particular, it is considered that the compound represented by the formula (1-1) reacts with water when water is present, to produce a compound represented by the following formula (a). Specifically, the compound represented by the formula (1-1) is particularly preferable since the compound represented by the formula (1-1) does not produce a free alcohol (e.g., the alcohol represented by the formula (b)) and a free carboxylic acid (e.g., R-C(=O)-OH). 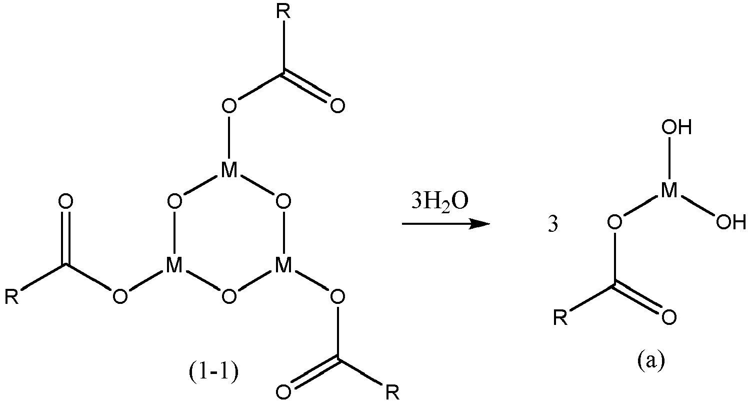 wherein R and M are the same as defined above.

### (2) Sealing resin

The sealing resin used in connection with one embodiment of the invention normally has a weight average molecular weight of 50,000 to 1,000,000, preferably 100,000 to 500,000, and more preferably 300,000 to 450,000, and exhibits adhesion.

A sealing resin having a weight average molecular weight within the above range is not liquid, and exhibits an excellent handling capability. If the weight average molecular weight is less than the above range, the resulting sealing material composition may have insufficient cohesive strength, and may contaminate the adherend. If the weight average molecular weight exceeds the above range, the resulting sealing material composition may have too high a cohesive strength, and may exhibit low flexibility and fluidity, whereby wettability with the adherend may become insufficient. Moreover, the sealing resin may exhibit decreased solubility in a solvent when preparing the sealing material composition.

Note that the term "weight average molecular weight" used herein refers to a polystyrene-equivalent weight average molecular weight determined by gel permeation chromatography (GPC).

Examples of the sealing resin include an acrylic-based resin, a silicone-based resin, a polyester-based resin, a rubber-based resin, and the like. It is preferable to use a rubber-based resin since a rubber-based resin has a low water vapor transmission rate.

A polyisobutylene-based resin, a polybutene-based resin, a synthetic rubber such as a styrene-based thermoplastic elastomer, a styrene-conjugated diene copolymer, and a styrene-olefin copolymer, and a natural rubber may be used as the rubber-based resin. Specific examples of the styrene-conjugated diene copolymer include an unhydrogenated styrene-conjugated diene copolymer such as a styrene-butadiene copolymer (SBR), a styrene-butadiene-styrene copolymer (SBS), a styrene-butadiene-butylene-styrene copolymer, a styrene-isoprene copolymer, a styrene-isoprene-styrene copolymer (SIS), and a styrene-ethylene-isoprene-styrene copolymer; a hydrogenated styrene-conjugated diene copolymer such as a styrene-ethylene/propylene-styrene copolymer (SEPS) (hydrogenated styrene-isoprene-styrene copolymer (SIS)), and a styrene-ethylene-butylene-styrene copolymer (SEBS) (hydrogenated styrene-butadiene copolymer); and the like.

Among these, a polyisobutylene-based resin is preferable, since the advantageous effects of the invention can be more easily achieved.

A polyisobutylene-based resin exhibits an excellent water vapor barrier capability, and does not decrease in water vapor barrier capability even after the moisture absorbent has absorbed water (moisture).

The term "polyisobutylene-based resin" used herein refers to a resin that includes a polyisobutylene skeleton (see the following structural unit (c)) in the main chain or the side chain.

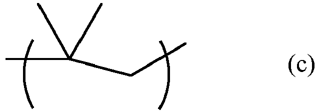

Examples of the polyisobutylene-based resin include polyisobutylene (isobutylene homopolymer), a copolymer of isobutylene and isoprene, a copolymer of isobutylene and n-butene, a copolymer of isobutylene and butadiene, halogenated butyl rubbers obtained by brominating or chlorinating these copolymers, and the like. When the polyisobutylene-based resin is a copolymer of isobutylene and n-butene, isobutylene is used as the main raw material monomer (i.e., a monomer that is used in the largest amount). These polyisobutylene-based resins may be used either alone or in combination.

When the polyisobutylene-based resin is used as the sealing resin, the content of the polyisobutylene-based resin in the sealing resin is preferably 60 to 100 mass%, more preferably 80 to 100 mass%, still more preferably 95 to 100 mass%, and particularly preferably substantially 100 mass%, from the viewpoint of improving the weatherability of the resulting sealing material composition.

The sealing material composition normally includes the moisture absorbent and the sealing resin in a mass ratio (moisture absorbent:sealing resin) of 10:100 to 100:100, and preferably 20:100 to 60:100. When the moisture absorbent and the sealing resin are used in a ratio within the above range, it is possible to obtain a sealing sheet according to one embodiment of the invention that exhibits excellent adhesion and an excellent water vapor barrier capability.

### (3) Tackifier

It is preferable that the sealing material composition according to one embodiment of the invention further include a tackifier so that the sealing material composition exhibits improved adhesion.

The tackifier is not particularly limited as long as the tackifier is compatible with the moisture absorbent and the sealing resin. A known natural resin-based tackifier, a synthetic resin-based tackifier, and the like may be used as the tackifier.

Examples of the natural resin-based tackifier include a rosin-based resin, a terpene-based resin, and the like. Examples of the rosin-based resin include a rosin such as gum rosin, tall rosin, and wood rosin; a modified rosin such as a hydrogenated rosin, a disproportionated rosin, and a polymerized rosin; a rosin ester such as a glycerol ester of a modified rosin, and a pentaerythritol ester of a modified rosin; and the like. Examples of the terpene-based resin include an α-pinene-based terpene resin, a β-pinene-based terpene resin, a dipentene (limonene)-based terpene resin, an aromatic-modified terpene resin, a hydrogenated terpene resin, a terpene phenolic resin, and the like.

Examples of the synthetic resin-based tackifier include a polymer-based tackifier such as a petroleum resin (e.g., aliphatic (C5) petroleum resin, aromatic (C9) petroleum resin, copolymer (C5-C9) petroleum resin, hydrogenated petroleum resin, and alicyclic petroleum resin), a cumarone-indene resin, and a pure monomer-based petroleum resin (e.g., styrene-based petroleum resin and substituted styrene-based petroleum resin), and a fused-type tackifier such as a phenolic resin (e.g., alkylphenol resin and rosin-modified phenolic resin) and a xylene resin.

These tackifiers may be used either alone or in combination. Among these, a petroleum resin is preferable, and an aliphatic (C5) petroleum resin is more preferable.

The tackifier is used in an appropriate amount taking account of the type of sealing resin, the type of tackifier, and the like. The tackifier is normally used in a ratio of 0 to 40 parts by mass, and preferably 5 to 30 parts by mass, based on 100 parts by mass of the sealing resin.

The sealing material composition according to one embodiment of the invention may include an additional component other than the above components as long as the object of the invention is not impaired.

Examples of the additional component include a light stabilizer, an antioxidant, a softener, a thermal stabilizer, a UV absorber, a filler, a plasticizer, and the like. Each additional component may be used in an appropriate amount taking account of the properties of each additional component, and the properties required for the sealing material composition.

The additional component is normally used in a ratio of 0 to 10 parts by mass based on 100 parts by mass of the sealing resin.

A solvent may be added to the sealing material composition according to one embodiment of the invention in order to improve applicability (described later). The solvent is preferably added so that the sealing material composition has a solid content of 10 to 30 mass%.

The solvent is not particularly limited as long as the solvent is compatible with the moisture absorbent and the sealing resin. Examples of the solvent include aliphatic hydrocarbons such as n-hexane and cyclohexane; aromatic hydrocarbons such as benzene, toluene, and xylene; halides thereof; esters such as ethyl acetate and butyl acetate; ketones such as methyl ethyl ketone and cyclohexanone; amides such as dimethylformamide; and the like. These solvents may be used either alone or in combination.

The sealing material composition according to one embodiment of the invention may be prepared by mixing the moisture absorbent, the sealing resin, and an optional additional component in a specific ratio, and mixing and defoaming the mixture using a known method, for example.

The sealing material composition according to one embodiment of the invention obtained as described above makes it possible to easily produce a sealing sheet that exhibits excellent transparency, an excellent water vapor barrier capability, and high adhesion.

Therefore, the sealing material composition according to one embodiment of the invention is suitably used as a sealing material that is used for an electronic device member for an organic EL display, a high-definition color liquid crystal display, and the like for which a high water vapor barrier capability is particularly required, for example.

### 2) Sealing sheet

A sealing sheet according to one embodiment of the invention includes a sealing layer that is formed using the sealing material composition according to one embodiment of the invention.

The sealing layer may be formed using a known method. For example, the sealing layer may be formed by applying the sealing material composition according to one embodiment of the invention to a base sheet using a known application (coating) method, and drying the resulting film.

The base sheet is not particularly limited. Examples of the base sheet include a synthetic resin film, paper, and the like.

Examples of a material for forming the synthetic resin film include polyethylene terephthalate, polyethylene, polypropylene, polybutene, polybutadiene, polymethylpentene, polyvinyl chloride, a vinyl chloride copolymer, polybutylene terephthalate, polyurethane, an ethylene-vinyl acetate copolymer, an ionomer resin, an ethylene-(meth)acrylic acid copolymer, polystyrene, a polycarbonate, a fluororesin, low-density polyethylene, linear low-density polyethylene, triacetyl cellulose, and the like.

Examples of the paper include high-quality paper, coated paper, glassine paper, laminated paper, and the like.

It is also possible to use a release sheet that is prepared by subjecting one side of the synthetic resin film or the paper mentioned above to a release treatment.

The release treatment may be implemented by applying a release agent (e.g., fluorine-based resin, silicone-based resin, or long-chain alkyl group-containing carbamate) to the surface of the base sheet.

A commercially-available product may be used directly as the release sheet.

The thickness of the base sheet is normally 5 to 300 µm, and preferably 10 to 200 µm, from the viewpoint of handling capability.

The sealing material composition (solution) according to one embodiment of the invention may be applied to the base sheet or the release sheet (release layer) using a known method (e.g., spin coating method, spray coating method, bar coating method, knife coating method, roll coating method, blade coating method, die coating method, or gravure coating method).

After applying the sealing material composition (solution) according to one embodiment of the invention to the base sheet, it is preferable to heat (dry) the resulting film at 80 to 150°C for 30 seconds to 5 minutes in order to prevent a situation in which the solvent and a low-boiling-point component remain in the film.

The thickness of the sealing layer is not particularly limited, and is appropriately selected taking account of the application of the sealing sheet, and the like. The thickness of the sealing layer is preferably 0.5 to 100 µm, more preferably 1 to 80 µm, and still more preferably 3 to 50 µm. When the thickness of the sealing layer is 0.5 µm or more, excellent adhesion to an adherend can be obtained. When the thickness of the sealing layer is 100 µm or less, it is advantageous from the viewpoint of productivity, and it is possible to obtain a sealing sheet that exhibits an excellent handling capability.

The sealing sheet according to one embodiment of the invention may further include a gas barrier layer so that the sealing sheet exhibits an improved gas barrier capability.

Examples of a material for forming the gas barrier layer include a silicon compound such as a polysilazane compound, a polycarbosilane compound, a polysilane compound, and a polyorganosiloxane compound; an inorganic oxide such as silicon oxide, silicon oxynitride, aluminum oxide, aluminum oxynitride, magnesium oxide, zinc oxide, indium oxide, and tin oxide; an inorganic nitride such as silicon nitride and aluminum nitride; an inorganic oxynitride such as silicon oxynitride; a metal such as aluminum, magnesium, zinc, and tin; and the like.

These materials may be used either alone or in combination.

The gas barrier layer may be formed using a method that is appropriately selected taking account of the type of material. For example, the gas barrier layer may be formed using a method that forms a layer of the above material on the base film using a deposition method, a sputtering method, an ion plating method, a thermal CVD method, a plasma CVD method, or the like, a method that applies a solution prepared by dissolving the above material (e.g., silicon compound) in an organic solvent to the base film, drying the resulting film, and implanting ions into the dried film using a plasma ion implantation method, or the like.

It is preferable to use the method that utilizes the plasma ion implantation method.

The plasma ion implantation method is a method that generates a plasma in an atmosphere that includes a plasma-generating gas, and implants ions (cations) included in the plasma into the surface area of the film by applying a negative high-voltage pulse to the film. The plasma ion implantation method may be implemented using the method disclosed in WO2010/107018, for example.

Examples of the ions that are implanted using the plasma ion implantation method include ions of a rare gas (e.g., argon, helium, neon, krypton, and xenon), a fluorocarbon, hydrogen, nitrogen, oxygen, carbon dioxide, chlorine, fluorine, sulfur, and the like; ions of a metal (e.g., gold, silver, copper, platinum, nickel, palladium, chromium, titanium, molybdenum, niobium, tantalum, tungsten, and aluminum); and the like.

The thickness of the gas barrier layer is preferably 1 nm to 10 µm, more preferably 10 to 1,000 nm, still more preferably 20 to 500 nm, and particularly preferably 50 to 200 nm.

The gas barrier layer may include only a single layer, or may include a plurality of layers. An anchor coat layer may be provided between the gas barrier layer and the base film in order to improve the smoothness-flatness of the base film.

The sealing layer and the gas barrier layer may be stacked using a method that laminates the gas barrier layer (gas barrier film) (provided with the base film) that has been formed as described above on the sealing layer so that the gas barrier layer is situated on the inner side (i.e., situated on the side of the sealing layer), a method forms the gas barrier layer directly on the sealing layer using the above method, or the like.

The sealing sheet according to one embodiment of the invention may have a structure in which another release sheet is bonded to the sealing layer so that the release-treated surface is situated on the inner side.

Examples of the layer configuration of the sealing sheet according to one embodiment of the invention include a release sheet/sealing layer/release sheet configuration, a release sheet/sealing layer/gas barrier layer configuration, a release sheet/sealing layer/gas barrier layer/base film configuration, a release sheet/sealing layer/gas barrier layer/release sheet configuration, and the like. It is preferable that the sealing sheet according to one embodiment of the invention have a release sheet/sealing layer/release sheet configuration, or a release sheet/sealing layer/gas barrier layer/base film configuration, since the sealing sheet can be stored and transported in a wound state, for example.

The sealing sheet according to one embodiment of the invention exhibits an excellent water vapor barrier capability. The water vapor transmission rate of the sealing sheet according to one embodiment of the invention at a temperature of 40°C and a relative humidity of 90% (90%RH) is preferably 0.1 to 5,000 g/m²/day, more preferably 0.1 to 1,000 g/m²/day, still more preferably 0.1 to 500 g/m²/day, and particularly preferably 0.1 to 50 g/m²/day. The water vapor transmission rate may be measured using a known method.

The sealing sheet according to one embodiment of the invention exhibits excellent moisture absorption properties. The moisture absorption of the sealing sheet according to one embodiment of the invention at a temperature of 40°C and a relative humidity of 90% (90%RH) is normally 0.5 g/m² or more, and preferably 1.0 g/m² or more. The moisture absorption of the sealing sheet may be measured using the method described later in connection with the examples.

The sealing sheet according to one embodiment of the invention produces an excellent result when subjected to the water entry test described later in connection with the examples. Specifically, the sealing sheet according to one embodiment of the invention exhibits an excellent gas barrier capability and excellent moisture absorption properties, and prevents a situation in which the sealing target (calcium layer) deteriorates (corrodes) due to water. Therefore, the sealing sheet according to one embodiment of the invention ensures excellent long-term reliability when applied to an organic EL display, a high-definition color liquid crystal display, and the like for which a high barrier capability is particularly required.

The sealing sheet according to one embodiment of the invention exhibits excellent transparency. The total light transmittance of the sealing sheet according to one embodiment of the invention is normally 80% or more, and preferably 90% or more.

The sealing sheet according to one embodiment of the invention also exhibits excellent adhesion.

The sealing sheet according to one embodiment of the invention preferably exhibits an adhesion (N/25 mm) of 3.5 N/25 mm or more when subjected to the adhesion test described later in connection with the examples.

### 3) Electronic device member and electronic device

An electronic device member according to one embodiment of the invention includes the sealing sheet according to one embodiment of the invention. Specifically, the electronic device member according to one embodiment of the invention exhibits excellent transparency, an excellent water vapor barrier capability, and high adhesion, and can be easily obtained. Therefore, the electronic device member according to one embodiment of the invention is suitable as a member (e.g., electrode substrate) for a display (e.g., liquid crystal display and EL display), a solar cell, and the like.

Examples of an electronic device according to one embodiment of the invention include an organic device such as an organic transistor, an organic memory, and an organic EL device; a liquid crystal display; electronic paper; a thin film transistor; an electrochromic device; an electrochemical light-emitting device; a touch panel; a solar cell; a thermoelectric conversion device; a piezoelectric conversion device; an electrical storage device; and the like.

Examples of the device include a photoelectric conversion device such as a device that converts electrical energy into light (e.g., light-emitting diode and semiconductor laser), and a device that converts light into electrical energy (e.g., photodiode and solar cell); a light-emitting device such as an organic EL device; and the like. The type, the size, the shape, the number, and the like of the device(s) formed on the transparent substrate are not particularly limited as long as the device can be sealed using the adhesive composition according to one embodiment of the invention.

An organic EL device may be sealed using the sealing sheet according to one embodiment of the invention as described below. For example, a sealing sheet having a release layer/release sheet configuration, and a gas barrier film having a gas barrier layer/base film configuration, are compression-bonded at room temperature so that the sealing layer of the sealing sheet is opposite to the gas barrier layer of the gas barrier film, to produce a laminate having a release sheet/sealing layer/gas barrier layer/base film configuration. After removing the release film from the sealing layer, the resulting laminate is compression-bonded at room temperature using a laminator or the like so that the sealing layer come in contact with (seals) the organic EL device.

Alternatively, the sealing layer may be placed on an organic EL device or the like, and the gas barrier layer may be stacked on the sealing layer.

For example, a sealing sheet having a sealing layer/release sheet configuration is placed to cover the organic EL device so that the sealing layer is situated on the inner side (i.e., situated on the side of the organic EL device). After removing the release sheet, a gas barrier film having a gas barrier layer/base film configuration is placed on the laminate, and the resulting laminate is compression-bonded at room temperature. The organic EL device can thus be sealed using the sealing sheet according to one embodiment of the invention that has a sealing layer/gas barrier layer/base film configuration.

The electronic device according to one embodiment of the invention includes the electronic device member that includes the sealing sheet according to one embodiment of the invention. Therefore, the electronic device according to one embodiment of the invention exhibits excellent transparency, an excellent water vapor barrier capability, and excellent adhesion.
The electronic device according to one embodiment of the invention exhibits an excellent water vapor barrier capability, long-term reliability, and the like when the electronic device is subjected to the organic EL device evaluation test and the like described later in connection with the examples, for example.

### EXAMPLES

The invention is further described below by way of examples. Note that the invention is not limited to the following examples.

### Example 1

100 parts by mass of an isobutylene-based resin ("ExxonButyl 268" manufactured by Japan Butyl Co., Ltd., isobutylene-isoprene copolymer, weight average molecular weight: 260,000) (sealing resin), 20 parts by mass of a tackifier ("Quintone A-100" manufactured by Zeon Corporation, aliphatic petroleum resin), and 25 parts by mass of the compound represented by the formula (1) ("Algomaer 800AF" manufactured by Kawaken Fine Chemicals Co., Ltd.) were dissolved in toluene to obtain a sealing material composition 1 having a solid content of 20 mass%.

### Examples 2 to 6 and Comparative Examples 1 to 4

Sealing material compositions 2 to 6 and 1r to 4r were obtained in the same manner as in Example 1, except that a moisture absorbent among the moisture absorbents [A] to [G] listed in Table 1 was used as the moisture absorbent in the amount listed in Table 1. The details of the moisture absorbents [A] to [G] are as follows. Note that "*" in the following formulas indicates the bonding position of R.

Moisture absorbent [A]: Algomaer 800AF manufactured by Kawaken Fine Chemicals Co., Ltd.
Moisture absorbent [B]: Algomaer 1000SF (n-C18) manufactured by Kawaken Fine Chemicals Co., Ltd.
Moisture absorbent [C]: Algomaer (n-C8) manufactured by Kawaken Fine Chemicals Co., Ltd.
Moisture absorbent [D]: Algomaer (n-C12) manufactured by Kawaken Fine Chemicals Co., Ltd.
Moisture absorbent [E]: Algomaer (2-ethylhexanoic acid) manufactured by Kawaken Fine Chemicals Co., Ltd.
Moisture absorbent [F]: ORGATIX TA-30 manufactured by Matsumoto Fine Chemical Co., Ltd.
Moisture absorbent [G]: ORGATIX TA-90 manufactured by Matsumoto Fine Chemical Co., Ltd.

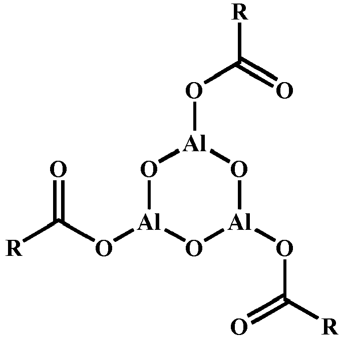

[A]: 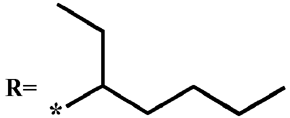
[B]: 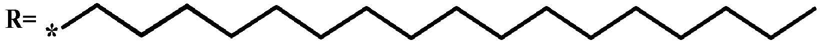
[C]: 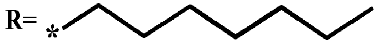
[D]:

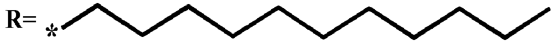

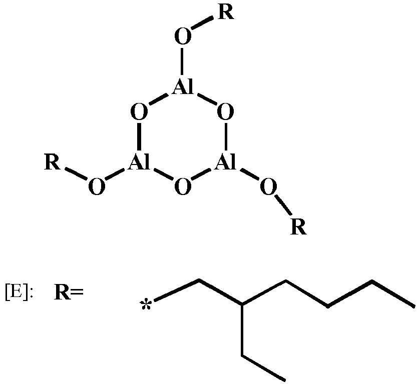

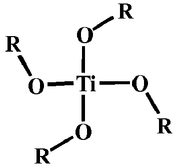

[F]: 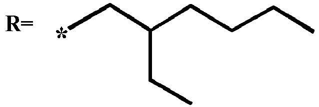
[G]:

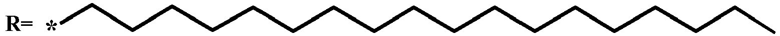

The moisture absorption was measured as described below using the sealing material compositions 1 to 6 and 1r to 4r obtained in Examples 1 to 6 and Comparative Examples 1 to 4. The measurement results are listed in Table 1.

### Measurement of moisture absorption

A sealing layer having a thickness of 50 µm was formed on soda lime glass (i.e., an adherend that does not change in weight) using the sealing material composition to obtain a laminate. After measuring the initial weight of the laminate, the laminate was allowed to stand under hygrothermal conditions (temperature: 40°C, humidity: 90%RH) for 24 hours, and the weight of the laminate was measured. The difference between the initial weight of the laminate and the weight of the laminate after being allowed to stand under the hygrothermal conditions was calculated, and taken as the moisture absorption (g/m²).

### Examples 7 to 12 and Comparative Examples 5 to 8

The sealing material composition obtained as described above (sealing material compositions 1 to 6 and 1r to 4r obtained in Examples 1 to 6 and Comparative Examples 1 to 4) was applied to the release-treated surface of a release sheet ("SP-PET382150" manufactured by Lintec Corporation). The resulting film was dried at 100°C for 2 minutes to form a sealing layer having a thickness of 20 µm. The release-treated surface of another release sheet ("SP-PET381031" manufactured by Lintec Corporation) was bonded to the sealing layer to obtain a sealing sheet (sealing sheets 1 to 6 and 1r to 4r).

The resulting sealing sheets 1 to 6 and 1r to 4r were subjected to the following adhesion measurement, water vapor transmission rate measurement, total light transmittance measurement, and water entry test. The results are listed in Table 1.

### Measurement of adhesion

The sealing sheet was bonded to a glass sheet at a temperature of 23°C and a relative humidity of 50% (50%RH) in accordance with JIS Z 0237 (revised edition published in 2000, adhesion measurement method). When 24 hours had elapsed, the peeling adhesive strength (180°) (N/25 mm) was measured.

### Measurement of water vapor transmission rate

The water vapor transmission rate of the sealing sheet was measured at a temperature of 40°C and a relative humidity of 90% (90%RH) using a water vapor transmission rate measurement apparatus ("L80-5000" manufactured by LYSSY).

### Measurement of total light transmittance

The total light transmittance of the sealing sheet was measured using a total light transmittance measurement device ("NDH-5000" manufactured by Nippon Denshoku Industries Co., Ltd.).

### Evaluation of water barrier capability

A calcium layer having a length of 35 mm, a width of 35 mm, and a thickness of 150 nm was formed on an alkali-free glass substrate (manufactured by Corning, 45×45 mm) using a vacuum deposition method. A sheet in which aluminum foil (7 µm) was stacked on a polyethylene terephthalate film (PET film) (thickness: 38 µm), was provided as a sealing base.

After removing the release sheet from the sealing sheet, the exposed sealing layer was bonded to the calcium layer formed on the glass substrate in a nitrogen atmosphere using a laminator, and the other release sheet was removed. The aluminum foil of the sealing base was stacked on the exposed sealing layer, and bonded using a laminator to obtain a water barrier capability test specimen in which the calcium layer was sealed.

The resulting specimen was allowed to stand for 500 hours at a temperature of 60°C and a relative humidity of 90% (90%RH), and the degree of discoloration of the calcium layer (i.e., the degree of entry of water (moisture)) was observed with the naked eye. The water barrier capability was evaluated in accordance with the following standard.

### Evaluation standard

A: Less than 20% (area ratio) of the calcium layer was discolored.
B: 20% or more and less than 40% (area ratio) of the calcium layer was discolored.
C: 40% or more (area ratio) of the calcium layer was discolored.

### Examples 13 to 18 and Comparative Examples 9 to 12

A glass substrate on which an indium tin oxide (ITO) film (thickness: 100 nm, sheet resistance: 50 Ω/sq.) (anode) was formed, was used.

N,N'-Bis(naphthalen-1-yl)-N,N'-bis(phenyl)-benzidine) (manufactured by Luminescence Technology) (50 nm), and tris(8-hydroxyquinolinato)aluminum (manufactured by Luminescence Technology) were sequentially deposited on the ITO film formed on the glass substrate at a deposition rate of 0.1 to 0.2 nm/min to form an emitting layer having a thickness of 50 nm.

Lithium fluoride (LiF) (manufactured by Kojundo Chemical Lab. Co., Ltd.) (4 nm, 0.1 nm/min) and aluminum (Al) (manufactured by Kojundo Chemical Lab. Co., Ltd.) (100 nm, 0.1 nm/min) (electron-injecting material) were deposited on the emitting layer to form a cathode. An organic EL device was thus obtained. Note that the degree of vacuum during deposition was set to 1×10⁻⁴ Pa or less.

The sealing sheet (sealing sheets 1 to 6 and 1r to 4r obtained in Examples 7 to 12 and Comparative Examples 5 to 8) was heated (dried) at 120°C for 60 minutes in a nitrogen atmosphere using a hot plate to remove water from the sealing sheet, and allowed to cool to room temperature (23°C). The sealing sheet was placed to cover the organic EL device formed on the glass substrate. After placing a gas barrier film on the sealing sheet, the laminate was compression-bonded at room temperature to seal the organic EL device to obtain a bottom-emission electronic device (electronic devices 1 to 6 and 1r to 4r).

The electronic device (electronic devices 1 to 6 and 1r to 4r) was subjected to a dark spot test (organic EL device evaluation test) (see below), and evaluated. The evaluation results are listed in Table 1.

### Organic EL device evaluation test

The electronic device (electronic devices 1 to 6 and 1r to 4r) was allowed to stand for 200 hours at a temperature of 23°C and a relative humidity of 50% (50%RH), and the organic EL device was driven to observe the presence or absence of a dark spot (i.e., an area in which light was not emitted). The organic EL device was evaluated in accordance with the following standard.
A: The ratio of a dark spot area was less than 5% with respect to the emission area.
B: The ratio of a dark spot area was 5% or more and less than 10% with respect to the emission area.
C: The ratio of a dark spot area was 10% or more and less than 90% with respect to the emission area.
D: The ratio of a dark spot area was 90% or more with respect to the emission area.

**TABLE 1**

| | Sealing material composition | | | | Moisture absorption | | |
|---|---|---|---|---|---|---|---|
| | Sealing resin (parts by mass) | Moisture absorbent | | Tackifier (parts by mass) | | | |
| | | Type | (parts by mass) | | | | |
| | | | | | (g/m²) | | |
| Example 1 | 100 | [A] | 25 | 20 | 0.78 | | |
| Example 2 | 100 | [A] | 50 | 20 | 1.59 | | |
| Example 3 | 100 | [B] | 25 | 20 | 0.68 | | |
| Example 4 | 100 | [B] | 50 | 20 | 1.42 | | |
| Example 5 | 100 | [C] | 50 | 20 | 1.52 | | |
| Example 6 | 100 | [D] | 50 | 20 | 1.36 | | |
| Comparative Example 1 | 100 | - | 0 | 20 | 0.05 | | |
| Comparative Example 2 | 100 | [E] | 50 | 20 | - | | |
| Comparative Example 3 | 100 | [F] | 50 | 20 | - | | |
| Comparative Example 4 | 100 | [G] | 50 | 20 | - | | |

| | Sealing sheet | Evaluation item | | | | Electronic device | Organic EL device evaluation test |
|---|---|---|---|---|---|---|---|
| | | Adhesion (N/25 mm) | Water vapor transmission rate | Total light transmittance | Water entry test | | |
| | | Glass | (g/m²/day) | (%) | | | |
| Example 1 | 1 | 8.4 | 12.6 | 91.42 | A | 1 | A |
| Example 2 | 2 | 6.2 | 14.1 | 90.96 | A | 2 | A |
| Example 3 | 3 | 4.6 | 14.5 | 91.44 | A | 3 | A |
| Example 4 | 4 | 3.8 | 14.3 | 90.86 | A | 4 | A |
| Example 5 | 5 | 6.5 | 15.1 | 91.18 | A | 5 | A |
| Example 6 | 6 | 5.9 | 14.8 | 91.39 | A | 6 | A |
| Comparative Example 1 | 1r | 8.6 | 6.2 | 91.65 | B | 1r | B |
| Comparative Example 2 | 2r | 2.2 | 15.2 | 80.22 | C | 2r | D |
| Comparative Example 3 | 3r | 2.8 | 11.8 | 83.22 | C | 3r | C |
| Comparative Example 4 | 4r | 2.4 | 12.2 | 83.49 | C | 4r | C |

The sealing sheets obtained using the sealing material compositions obtained in Examples 1 to 6 had a moisture absorption of 0.5 g/m² or more, and the sealing sheets 1 to 6 obtained in Examples 7 to 12 had an adhesion to a glass sheet of 3.8 N/25 mm or more, a water vapor transmission rate of 15.1 g/m²/day or less, and a total light transmittance of 90.8% or more (i.e., exhibited excellent transparency, an excellent water vapor barrier capability, and high adhesion) (see Table 1).

The sealing sheets were evaluated as "A" when subjected to the water entry test (i.e., exhibited an excellent water vapor barrier capability, an excellent sealing capability, and excellent long-term reliability).

As is clear from the evaluation results for the electronic devices 1 to 6 obtained in Example 13 to 18, a dark spot did not occur in the electronic devices obtained using the sealing sheets according to the embodiments of the invention.

On the other hand, the sealing sheet of Comparative Example 5 that was obtained using the sealing material composition obtained in Comparative Example 1 in which a moisture absorbent was not used, had small moisture absorption, and evaluated as "B" when subjected to the water entry test.

The sealing sheets of Comparative Examples 6 to 8 that were obtained using the sealing material compositions obtained in Comparative Examples 2 to 4 in which a metal alkoxide compound was used as the moisture absorbent, had poor adhesion and poor transparency, and evaluated as "C" when subjected to the water entry test.

As is clear from the evaluation results for the electronic devices 1r to 4r obtained in Comparative Example 9 to 12, the organic EL device deteriorated due to a primary alcohol produced by water vapor that absorbed moisture.

## Claims

1. A sealing material composition comprising a moisture absorbent, and a sealing resin having a weight average molecular weight of 50,000 to 1,000,000, the moisture absorbent comprising a compound that comprises a repeating unit represented by a formula (1), 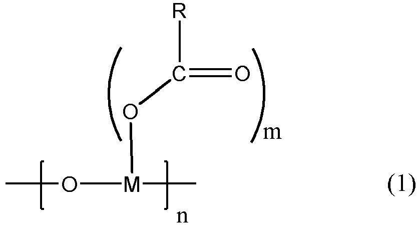 wherein M is an element selected from Al, Si, Ti, Ge, Zr, and a lanthanoid, R is an alkyl group having 1 to 30 carbon atoms, an alkenyl group having 2 to 30 carbon atoms, an aryl group having 6 to 30 carbon atoms, a cycloalkyl group having 3 to 20 carbon atoms, or a heterocyclic group, and n is a positive integer, provided that a plurality of repeating units represented by (-O-M(O-C(=O)-R)ₘ-) are either identical to or different from each other when n is equal to or larger than 2, m is 1 or 2, and a plurality of groups represented by -O-C(=O)-R are either identical to or different from each other when m is 2.

2. The sealing material composition according to claim 1, wherein the sealing resin is a polyisobutylene-based resin.

3. The sealing material composition according to claim 1 or 2, wherein the moisture absorbent is a compound represented by a formula (1-1), 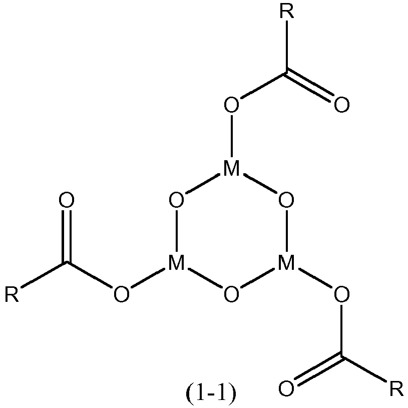 wherein R and M are the same as defined above.

4. The sealing material composition according to any one of claims 1 to 3, comprising the moisture absorbent and the sealing resin in a mass ratio (moisture absorbent:sealing resin) of 10:100 to 100:100.

5. The sealing material composition according to any one of claims 1 to 4, further comprising a tackifier.

6. A sealing sheet comprising a sealing layer that is formed using the sealing material composition according to any one of claims 1 to 5.

7. The sealing sheet according to claim 6, having a moisture absorption at a temperature of 40°C and a relative humidity of 90% of 0.5 g/m² or more.

8. The sealing sheet according to claim 6 or 7, further comprising a gas barrier layer.

9. An electronic device member comprising the sealing sheet according to any one of claims 6 to 8.

10. An electronic device comprising the electronic device member according to claim 9.
